# EUROPEAN PATENT APPLICATION

(11) **EP 4 772 890 A1**
(43) Date of publication of application: **08.07.2026**
(21) Application number: 25216131.0
(22) Date of filing: 17.11.2025
(51) Int. Cl.: G01R 29/12, G01W 1/16

(54) **ELECTRIC FIELD METER FOR THUNDERSTORM CLOUD**

(30) Priority: 18.11.2024 PL 45028924
(71) Applicant: Smycz, Eugeniusz, 75018 Paris (FR)
(72) Inventor: Smycz, Eugeniusz, 75018 Paris (FR)
(74) Representative: Warzybok, Tadeusz

(57) **Abstract**

The subject of the invention is an electric field meter for thunderstorm cloud, which has a grounded metal housing (1) in the shape of a cylindrical pipe, which in the middle upper part has a semi-pipe recess (2), serving as a measurement window (3), blinded with flat steel covers (4 and 4') connected to it non-detachably, whereby inside the housing (1) in its axis of symmetry, there is placed a dielectric tubular shaft (6) with metal angle rings (10 and 10'), on which is mounted a fixed grounded tubular metal internal measuring electrode (14) adjacent to this shaft, and to both faces of this shaft and the faces of both angle rings (10 and 10') are adjacent dielectric discs (11 and 11') with coaxially situated holes, in which are mounted dielectric two-stage cylindrical elements (13 and 13'), on the inner surfaces of the dielectric discs (11 and 11') in shallow ring sockets (12 and 12') the ends of the metal external measuring electrode (15) are mounted, glued with epoxy glue so that between both measuring electrodes a gap is formed, moreover inside the tubular shaft (6) a measuring system (26) is placed, whose reed switch (30) connected to a resistor (29) by an electric wire (31) is connected non-detachably to the external measuring electrode (15), while the resistor (29) connected to the inputs of the operational amplifier (28) by an electric wire (33) is connected non-detachably to the internal measuring electrode (14), which by an electric wire (35) is connected non-detachably to the grounded cover (4) of the housing (1), whereby the measuring system (26) is connected by an electric wire (43) to a control unit (38) connected by an electric wire (36) to a stepper motor (18), whose rotary shaft (19) is connected to a semicircular metal screen (21).

## Description

The subject of the invention is an electric field meter for thunderstorm cloud above the surface of a monitored building or above the surface of ground-mounted photovoltaic panels, protected against the effects of atmospheric discharges.

In weather conditions without clouds, there exists an electric field between the ionosphere and earth with an intensity of about 100 V/m, with negative charge accumulated on the earth's surface, resulting from the interaction of the positive charge of the ionosphere. In turn, in stormy conditions, clouds are charged with electric charge, which in temperate climate in their lower layers have negative charge, while in tropical climate they have positive charge. As a result of the existence of electric charge in the thunderstorm cloud, the electric field intensity both above or on the earth's surface changes and exceeds 1000 kV/m, whereby it has been found that a lightning strike is preceded by an increase in electric field intensity above or on the earth's surface reaching up to 15000 V/m.

During good weather, the atmospheric electrostatic field, directed vertically, which can be positive or negative, is in the order of 100 to 150 V/m. When an electrically charged thunderstorm cloud approaches, the atmospheric electrostatic field changes, then increases rapidly until it reaches a value, positive or negative, ranging from about 10 kV/m to many hundreds of kV/m, depending on the local geographical profile and altitude.

In buildings, especially metal warehouses, or metal containers, where the presence of people during a storm may cause them to be struck in case of an atmospheric discharge, information about the storm hazard allows for the development of an appropriate preventive procedure.

Moreover, currently many photovoltaic farms are being built, which are connected to the electrical grid, and an atmospheric discharge into power lines, regardless of surge protection devices, can cause damage to the electrical panels of these panels, especially to their sensitive electronic components, therefore it is advisable to disconnect the photovoltaic panel system from the power grid during a storm, hence early warning of an approaching storm is important to counteract its effects.

Therefore, information about the value of the electric field intensity is very important, which will help prevent the effects of atmospheric discharges, and thus ensure the protection of property and human life, especially in cases of:
- large gatherings of people in stadiums, squares, or recreational facilities (possibility of early evacuation);
- transshipment stations for flammable and/or hazardous materials;
- operating rooms (possibility of earlier switching to emergency power supply)
- buildings and structures without the presence of staff who can switch off and on the electrical power if necessary.

Warning devices for increasing electric field intensity above or on the ground in stormy cloud conditions are known. One of them is a warning device that only allows for the localization of discharges and tracking the movement of thunderstorm clouds, whose operation is based on electromagnetic wave measurements by cloud-to-ground or cloud-to-cloud atmospheric discharge. Other known solutions for measuring the local magnetic field on or above the earth's surface are the so-called "electric field mills" and "vibrating electrode systems". These are devices used for local warning, characterized by much greater precision of warnings of an approaching storm than devices based on electromagnetic wave measurements. The solution based on the electric field mill has a measuring electrode placed in the examined electric field and is equipped with a movable shutter, which cuts off the magnetic field at the moment of its closing and the appearance of horizontal electric field on the electrode at the moment of its opening, whereby this change generates an electrical signal giving an image of the existing electric field. In turn, the device constituting a system with a vibrating electrode has a membrane electrode placed in the examined electric field, which as a result of vibration changes the distance from the electrode having a constant potential, changing the capacity of the thus formed capacitor, whereby this change generates an electrical signal giving an image of the existing electric field. The solution mentioned above, despite its widespread use, has a significant disadvantage consisting in the fact that the measurement of the electric field takes place directly in this field, which causes that for the measuring system, in addition to the measured electric field, an electric field interfering with the real field is also transmitted. The sum of these two fields constitutes the resultant field, which results in an electrical signal with large disturbances. In turn, recovering the signal from the real field, that is the electrostatic or slowly changing field, whose source is the electric charge of the thunderstorm cloud, requires numerical processing, which increases the cost of this device.

Methods of registering atmospheric discharges are also known, of which the first, consisting in monitoring storm activity, is based on satellite optical observations of lightning occurring in thunderstorm clouds. It provides detailed information from the area observed at a given moment by instruments placed on the satellite. The second of these methods of storm tracking consists in detecting electrostatic signals generated by atmospheric discharges in the VLF, HF and VHF radio ranges. This method allows for the assessment of the intensity of discharges and their position, and its disadvantage is the range of signals, which in these frequency ranges are received at distances of up to several hundred kilometres in the HF range and several thousand kilometres in the VLF range, and covering large areas with observation stations requires a dense distribution of tracking stations. In turn, the existing and currently most expanded monitoring system is based on the analysis of signals recorded simultaneously in the VLF and HF range, whereby it covers only highly developed countries, covering a small percentage of the Earth's surface, while the third of the above methods is based on tracking signals exclusively in the VLF range, for which the range of a single station reaches up to a thousand kilometres. The above-described methods of observing atmospheric discharges due to the high cost of installation do not allow for monitoring of global storm activity over the entire Earth area. In addition, none of these methods allows for obtaining 100% detection effectiveness of discharges, and it is currently estimated that their effectiveness reaches 60% to 80%, depending on the method used and the complex and costly signal analysis algorithms used.

In turn, known from Polish patent application description No. P.382624, a method of monitoring storm activity on the earth's surface in real time consists in analysing electromagnetic signals excited by electric discharges in storm cells. The essence of this method is that signals of the ELF (Extremely Low Frequency) electromagnetic field are recorded in the earth-ionosphere resonator, they are subjected to spectral analysis based on resonance preparation models in the earth-ionosphere waveguide, then features dependent on the distance and intensity of the source are extracted and compared with the parameters of the model database. The closest set of basic parameters reproduces the position and intensity of the sources. The analysis can be conducted in real time, and its results can be presented in the form of storm activity maps.

In turn, the device for applying this method has two inductive active magnetic antennas, perpendicular to each other according to the NS and EW directions and placed on the surface or at a shallow depth under the ground surface. The antennas are connected by screened conductors to the observation signal registration block. The block contains two identical signal paths with amplifiers, filters, analogue-to-digital converters, and a control system. The clock of the control system is synchronized by the system receiver with GPS time. The electronic data processing unit is programmed according to the spectral analysis algorithm of elf analysis and the algorithm for determining features dependent on the distance and activity of thunderstorm discharge sources.

Also known from Japanese patent description No. JP11160428 is a device predicting lightning, equipped with a part searching for past examples of detonation similar to the current meteorological state. This device outputs past meteorological states similar to current decision elements concerning lightning according to the output data of the device displaying the image of the lightning danger level and decision elements recorded in the meteorological states data file and the lightning prediction decision device taking into account past examples of detonation. This device gives an output of lightning prediction result taking into account past examples according to the output data of the device displaying the image of lightning danger level, as well as past meteorological states from the part searching for past examples and the device graphically displaying output data. As a result, not only the current meteorological state, but also past examples of detonation similar to the current meteorological state are searched for and taken into account in predicting a more accurate lightning strike.

Also known from Japanese patent description JP11160453A, a device searching for a case of lightning strike, has an operational device determining search points, which determines a set of search points on the echo intensity image or on the image of the danger level of lightning generation on the image display and a device establishing search point data, which establishes searched key data, which consist of: time, coordinates, probable value of lightning strike assessment appropriate for this set of search points. In the database of searched key data of this device, the searched key data of past meteorological cases are previously recorded, whereby the device for processing search data searches from the key data database, searched data a certain set of searched key data from the same time having similar times, coordinates and values of lightning generation assessment elements to those determined for search points and determines the degree of similarity. In turn, the device displaying the search result displays information about the time and degrees of similarity of a certain set, for which the degrees of similarity are equal to a certain reference value as the resulting searched case. As a result of these searches, it becomes possible to estimate and assess the probability of a lightning strike in the future.

In turn, known from patent description US5621410A, remote prediction of lightning danger consists in applying a device and a method for detecting the electrical orientation of particles at upper levels of electrified thunderstorm clouds. These storms are illuminated by radar in one or more orthogonal polarizations, and co-polar and cross-polar returns are correlated coherently and incoherently. The correlation coefficient or some function of it is examined to determine the degree of consistent orientation of particles, and thus the degree of electrification and the possibility of lightning, whereby the phase of correlation reduction in coherent processing also detects the orientation of particles, which can be included in the decision determining predictions, while this correlation and phase can be displayed, recorded or used to predict or warn of lightning occurrence.

From patent description No. EP2041586A2, a device for detecting storms is known, comprising at least one pair of electrodes for measuring the atmospheric electrostatic field, a rotary screen capable of simultaneously subjecting each electrode from at least one pair of electrodes to the action of the atmospheric electrostatic field, and then simultaneously isolating each electrode from at least one pair of electrodes from the atmospheric electrostatic field, and a central processing unit capable of processing signals from the electrodes to determine the possible risk of a storm, which is characterized in that the rotary screen comprises a disc having slots adapted to uncover the electrodes during a part of the rotation of this screen for exposure to the action of the atmospheric electrostatic field, whereby the shape of each of these slots is such that the signal from at least one measuring electrode during the rotation of the rotary screen is substantially sinusoidal.

French patent description No. FR2432719A1 discloses a device for detecting a storm, comprising an apparatus for measuring the atmospheric electrostatic field of the Franklin mill type. The device comprises a rotary screen adapted to place a first pair of measuring electrodes in the atmospheric electrostatic field, while a second pair of measuring electrodes is isolated from the atmospheric electrostatic field, then to isolate the first pair of measuring electrodes from the atmospheric electrostatic field, while the second pair of measuring electrodes is placed in the atmospheric electrostatic field. The amplitude of the alternating voltage at the terminals of the electrodes is measured and then compared with a voltage threshold. When the amplitude exceeds the voltage threshold, an alarm is generated. The rotary screen comprises two discs substantially with such fields as the electrode discs, connected by an arm.

The disadvantage of the device is that the modulated signal received on the electrodes has a complicated shape, which makes signal processing difficult. In addition, the electrodes are particularly exposed to external disturbances, such as for example rain, hail, snow, or dust.

Also known from Polish patent description PL226103B1 is "A method and device for measuring the magnitude of electric field intensity during the occurrence of thunderstorm clouds above the surface of a monitored building", whereby the essence of this method is that on the building protected against the effects of atmospheric discharges, a device is installed equipped, depending on its type, with a rotary set composed of: a collecting electrode collecting and retaining electric charge induced by the electric field (E) of the thunderstorm cloud and a dielectric or two collecting electrodes isolated by two dielectrics, or a collecting electrode with a contact and a measuring system equipped with a fixed measuring electrode or two fixed measuring electrodes electrically connected through a resistor with an amplifying-processing system equipped with a microprocessor and an analogue-to-digital converter, whose output is connected to the power control system of this monitored building, then from the moment of the appearance of thunderstorm clouds charged with negative (Q-) or positive (Q+) electric charge generating an electric field (E) above this building, the appropriate set of the collecting electrode with the dielectric, or two collecting electrodes with their two dielectrics or the collecting electrode, is set in rotary motion, as a result of which electric charge (Q+) is induced on their upper surfaces, and electric charge (Q-) on their lower surfaces, and moreover, the rotary motion of the appropriate collecting electrode above the measuring electrode causes capacitive coupling and momentary electrical connection between them or contact coupling, during which the transformation of this electric field into monopolar charges (Q+) and (Q-) takes place, giving at the output of the amplifying-processing system information about the magnitude of the intensity of this field in V/m, which is given to the input of the microprocessor of this system and is recorded in its memory, and when the intensity of the electric field (E) of the thunderstorm cloud is at least 500 V/m, this information constitutes an indicator of the risk of an electric discharge, which after being processed into a digital signal by the analogue-to-digital converter of this system is currently transferred to the electrical executive devices of the monitored building, which depending on the value of the intensity of this electric field automatically activates appropriate devices installed in this building causing light and/or sound signalling, or cause the complete disconnection of this building from the power grid supplying it. The measurement of the value of the monopolar charge, and thus the intensity of the electric field (E) accumulated on the collecting electrode is made in the measuring chamber of the monitoring device (U) through capacitive coupling of this electrode with the measuring electrode of the measuring system. Capacitive coupling of the collecting electrodes with the measuring electrodes is realized during the rotary motion of a given collecting electrode, preferably at a rotational speed of 0.1-10 rotations/sec. Advantageously, the surfaces of the cooperating collecting electrodes and measuring electrodes are the same and amount to 1-100 cm², and the distance between them at the moment of their capacitive coupling preferably does not exceed 5 mm, whereby the collecting electrodes are isolated by a dielectric from the other structural elements of the monitoring device.

In turn, the essence of the device for measuring the magnitude of electric field intensity during the occurrence of thunderstorm clouds above the surface of a monitored building protected against the effects of atmospheric discharges according to this invention is that it consists of a charging chamber and a measuring chamber, which are separated from each other by a partition equipped with a rotary assembly or an ordinary partition, whereby in the charging chamber there is a collecting electrode, collecting electric charges induced by the electric field (E) of the thunderstorm cloud, placed partially on a dielectric element, mounted eccentrically on a rotary assembly with a vertical axis of rotation, or in the charging chamber there are two collecting electrodes also placed partially on two dielectric elements attached eccentrically in the rotary assembly, or in the charging chamber there is a collecting electrode mounted on the face of a vertically situated dielectric element attached eccentrically on a rotary element with a horizontal axis of rotation, while the measuring chamber of this device is equipped with an internal housing with slit recesses in its vertical wall, enabling the rotation of the collecting electrode together with its dielectric element and a measuring system equipped with a fixed measuring electrode situated horizontally at a height enabling the rotation of this dielectric just above it, or the measuring chamber is equipped with a measuring system containing two vertically situated two measuring electrodes also just under the two collecting electrodes rotating above their faces with their two dielectric elements, whereby all fixed measuring electrodes of the measuring system are electrically connected to the amplifying-processing system of this measuring system, which consists of a resistor and a field-effect transistor, a transistor amplifier and a microprocessor µP with an analogue-to-digital converter input, whose output is used to connect the protected building, whereby the measuring chamber of this device is completely isolated from the external electric field (E) of the thunderstorm cloud. In addition, the charging chamber of this device is equipped with a contact conducting element connecting the rotary collecting electrode with the metal housing of this chamber, and above this electrode there is a collecting electrode electrically connected through a feedthrough - insulated electrical conductor with an intermediate electrode.

It was established that during the use of the device according to this invention, it fulfils its function properly in a stable manner in field conditions without rainfall, presenting correct measurement results of the electric field intensity during the occurrence of thunderstorm clouds.

At the same time, it was found that already in the initial phase of rainfall, this device presented erroneous measurement results. It was observed that during rainfall, accumulating water drops cause a change in the charge distribution of the collecting electrode, which strongly weakens the signal concerning the electric field. This phenomenon, among others, prevents the stable operation of this device in various weather conditions.

The aim of the invention is to develop the construction of an electric field intensity meter during the occurrence of thunderstorm clouds above the surface of both a monitored building and ground-mounted photovoltaic panels, eliminating the disadvantages and inconveniences of the known technical solutions mentioned above. The aim of the invention is also to develop such a meter construction that will allow obtaining correct results of measuring the electric field intensity during the occurrence of thunderstorm clouds, and its stable operation in field conditions both without rainfall and during rainfall and at varied ambient temperatures, both positive and negative.

The electric field meter for thunderstorm cloud according to the invention has a grounded metal housing in the shape of a cylindrical pipe with a length L= 480 - 520 mm and a diameter Ø = 190 - 210 mm, which in the middle upper part has a semi-pipe recess with a length L1 = 190 - 210 mm, serving as a measurement window, whereby one external opening of this housing is blinded with a flat steel cover fitted in it and connected to it non-detachably with an axial through hole, and the second external opening is also blinded with a flat steel cover fitted in it and connected to it non-detachably. Inside the meter housing in its axis of symmetry, there is placed a tubular shaft made of dielectric material with an external diameter Ø1= 75 - 84 mm, having at both its ends external ring recesses connected detachably with metal angle ring, on which is mounted a fixed grounded tubular metal internal measuring electrode adjacent to the tubular shaft. In turn, to both faces of the tubular shaft and the faces of both angle rings are adjacent dielectric discs with coaxially situated holes with a diameter equal to the diameter of this shaft, in which are mounted dielectric two-stage cylindrical elements screwed into both ends of the tubular shaft. On the inner surfaces of the dielectric discs, shallow ring sockets are made, in which the ends of the metal external measuring electrode are mounted, glued with epoxy glue, and between this electrode and the metal internal measuring electrode, a gap with a height h = 1 - 5mm is formed. Inside the tubular shaft, a measuring system is placed, whose reed switch connected to a resistor, by an electric wire placed in the hole of this shaft, is connected non-detachably to the external measuring electrode, while the resistor connected to the inputs of the operational amplifier by another electric wire through another hole of the tubular shaft is connected non-detachably to the internal measuring electrode, which by an electric wire is also connected non-detachably to the grounded cover of the meter housing, whereby the measuring system is connected by an electric wire through wires placed in the tubular guide mounted in the through hole of one of the meter covers and inside the axial hole of the two-stage cylindrical element and partially inside the tubular shaft with the control unit controlling the operation of the stepper motor connected to it by an electric wire and mounted in the steel support element welded to the inner surface of the housing behind the second meter cover. The rotary shaft of the stepper motor, powered by direct current with a voltage of 12 - 48 V from batteries through a steel arm is connected to a semi-circular metal screen with an internal diameter Ø5 = 178 - 182 mm, which is also connected to two ball bearings mounted on the external ends with larger diameters of both dielectric two-stage cylindrical elements, and moreover, the rotary shaft of the stepper motor by means of a carbon brush is connected to a steel element adjacent to the face of one dielectric two-stage cylindrical element and welded to the inner surface of the meter housing.

The measuring system of the meter placed in a metal housing of the Faraday cage type, consists of a microprocessor with an A/D converter, an operational amplifier, a resistor with a resistance R = 4 - 6 MΩ and a reed switch.

In turn, the control unit placed in a technical room powered from the electrical grid with alternating current with a voltage of 230V is equipped with batteries with a voltage of 12V - 48V, an LCD type liquid crystal screen - display, LED diodes and with controlling light outputs with relays of measurement data and is wirelessly connected to a computer, with light-sound signalling and the signalling and executive devices.

The steel screen is set in rotary motion by a stepper motor and performs only half of the two-way rotations, and both measuring electrodes are electrically connected to each other by means of a resistor.

Advantageously, the tubular shaft, both discs and both two-stage cylindrical elements are made of Teflon or polysulfone, and both measuring electrodes are made of brass or stainless steel or copper, while the meter housing, its covers and structural elements are made of stainless steel.

It is also advantageous when the electric wires connecting the control unit with the stepper motor and the measuring system are screened wires.

The meter according to the invention allows for accurate measurements of the electric field intensity of a thunderstorm cloud, enabling taking preventive actions in case of detecting an approaching storm minimizing its effects.

The construction of this meter, whose measuring electrodes are placed in a metal housing with a cut-out hole - a measurement window, enables measuring the electric field intensity of a thunderstorm cloud directed perpendicular to the external measuring electrode and does not allow for disturbances of the direction of this field by electrified structural elements of this meter. Appropriately selected sizes of measuring electrodes, their mutual positioning relative to each other at a distance of 1-5 mm and appropriately selected size of the metal housing of this meter causes that the electric field at the external surface of the external measuring electrode does not have a component parallel to the surface of this electrode, which in turn ensures the stability of measurements of electric field intensity in various weather conditions (rain, hail, wind, temperature). Due to the fact that dielectrics tend to accumulate electric charge, the external measuring electrode of the meter is only with its ends glued with epoxy glue to the shallow ring sockets of the dielectric discs, which eliminates the generation of an electric field generating false alarms. In turn, the use of a metal screen allows for closing the measurement window and creating the so-called Faraday cage in order to obtain zero electric field inside it originating from the thunderstorm cloud and zeroing the electric charges on the measuring electrodes.

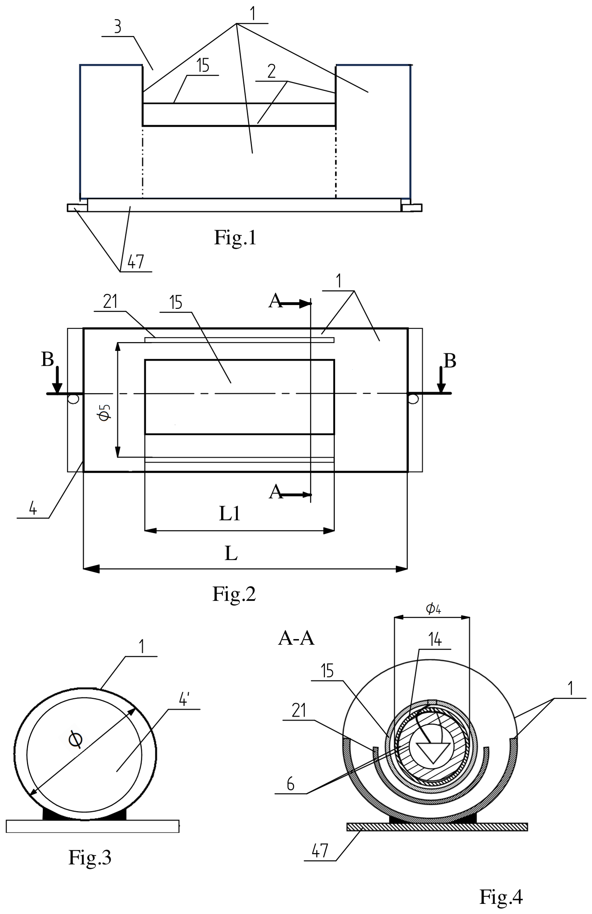

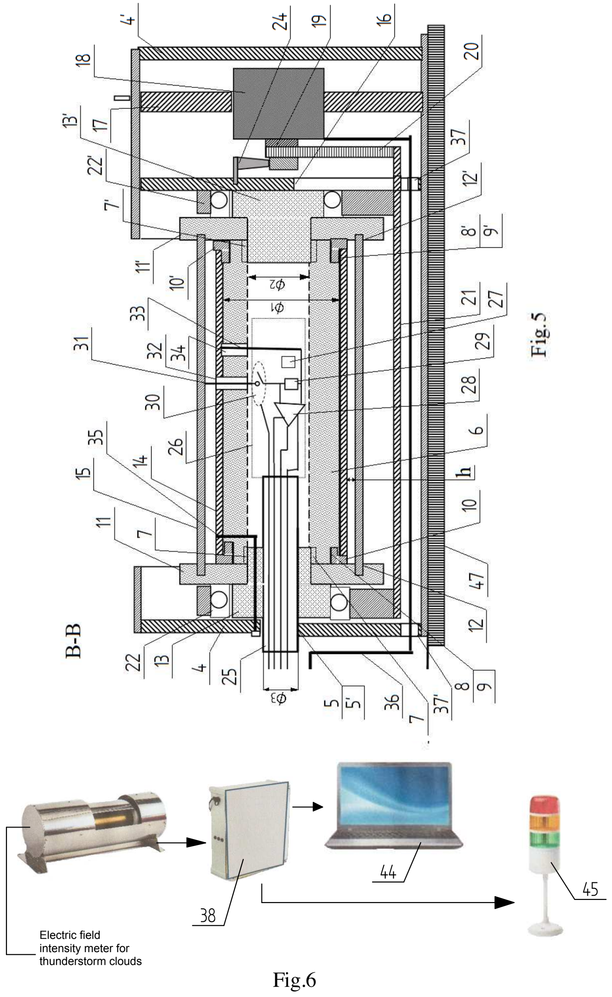

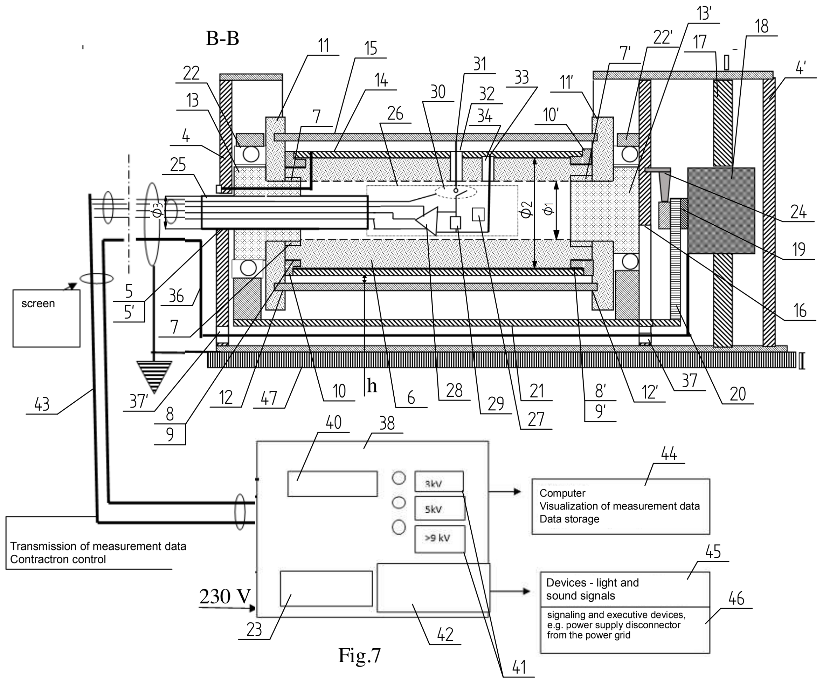

The subject of the invention has been more closely explained in the drawing, in which fig. 1 shows the electric field intensity meter for thunderstorm clouds in front view, fig. 2 - the same meter in top view, fig. 3 - the same meter in side view, fig. 4 - the same meter in axial section along line A - A, fig. 5 - the same meter in transverse axial section along line B - B, fig. 6 - a set of devices functionally connected with this meter in perspective views, fig. 7 - the same meter in transverse axial section along line B - B together with a block diagram of external devices cooperating with it, fig. 8 - location of the electric field meter of the thunderstorm cloud relative to this cloud and its electric field and the monitored building, equipped with a control unit powered by 230V current from the grid of this building and wirelessly connected to signalling devices and control of executive devices, in a block diagram, fig. 9 - location of the electric field meter of the thunderstorm cloud relative to this cloud and its electric field connected to a control unit situated in a technical room and its location relative to monitored photovoltaic panels mounted on the ground, in their block diagram, fig. 10 - diagram of the electric field of the thunderstorm cloud inducing on the metal housing of this meter and on the external surface of the external measuring electrode of this meter a positive electric charge for a negatively charged thunderstorm cloud, fig. 11 - simplified diagram with induced negative electric charge on the inner surface of the external measuring electrode and positive electric charge on its external surface and positive charge on the external surface of the internal measuring electrode of this meter, fig. 12 and 13 - diagrams of the electric field of the thunderstorm cloud inducing electric charges on the metal housing of this meter and on both its metal electrodes, after performing a half-turn of the metal semi-circular screen, fig. 14 - the principle of measuring the electric field intensity of the thunderstorm cloud using the intensity meter of this field in a block diagram, and fig. 15 - a graph of the measured electric field of the thunderstorm cloud from a distance of 15 km from protected facilities located in the south-eastern part of Poland.

The invention should not be limited to the examples of embodiment described below, as it may also be implemented in other forms. The examples of embodiment are presented in such a way as to fully and completely disclose the invention and to fully convey the scope of the invention to persons skilled in the art.

In summary, the examples of embodiment presented below do not exhaust all possible solutions within the spectrum of the essence of the invention.

The electric field intensity meter for thunderstorm cloud has a grounded housing 1 in the shape of a cylindrical pipe made of stainless steel with a length L = 500 mm and a diameter Ø = 200 mm, which in the middle upper part has a semi-pipe recess 2 with a length L1 = 200 mm, serving as a measurement window 3. One external opening of this housing is blinded with a flat steel cover 4 fitted in it non-detachably with an axial through hole 5, and the second external opening is blinded with a flat steel cover 4' also fitted in it non-detachably.

Inside the housing 1 in its axis of symmetry, there is placed a tubular shaft 6 made of Teflon with an external diameter Ø1 = 80 mm and an internal diameter Ø2 = 30mm, with internal threads 7 and 7' made at both its ends and with external ring recesses 8 and 8' with external threads 9 and 9', on which metal angle rings 10 and 10' are screwed. To both faces of the tubular shaft 6 and the faces of both rings 10 and 10' are adjacent discs 11 and 11' made of Teflon (dielectric) with coaxial holes with diameters equal to the internal diameter Ø2 of the tubular shaft 6, which on the inner surfaces in their upper parts have shallow ring sockets 12 and 12' made. Moreover, in the hole of the tubular shaft 6 at one of its ends is screwed one threaded end of a two-stage cylindrical element 13 made of Teflon (dielectric) also mounted in the hole of disc 11 with an axial hole 5' with a diameter Ø3 analogous to that of the through hole 5 of cover 4, while at the other end of the tubular shaft 6 in its hole is screwed one end of the second uniform two-stage cylindrical element 13' also made of Teflon, mounted also in the hole of disc 11', so that the inner surfaces of discs 11 and 11' are closely adjacent to both face surfaces of the tubular shaft 6 and both face surfaces of the two-stage cylindrical elements 13 and 13'. In addition, on the tubular shaft 6 and on the angle rings 10 and 10' connected to it, a fixed tubular brass grounded internal measuring electrode 14 with an external diameter Ø4 = 85mm is mounted, while in the shallow ring sockets 12 and 12' of both discs 11 and 11', the ends of the brass external measuring electrode 15 are mounted, glued to them with epoxy glue, ensuring minimal contact of this electrode with the dielectric discs 11 and 11', in order to maximize the elimination of the formation of electric charge on this measuring electrode, whose source are dielectric materials, which charge in turn is a source of interference in the measurement of the electric field intensity of the thunderstorm cloud.

Moreover, between both measuring electrodes 14 and 15, a gap with a height h = 2 mm is formed. In turn, between the cover 4' of the housing 1 and the face wall of the dielectric two-stage cylindrical element 13', a flat steel structural element 16 is welded to the inner surface of the housing 1, and between this element and the cover 4', a steel support structural element 17 is welded to the housing 1 with a stepper motor 18 mounted in it, whose rotary shaft 19 is connected to one end of a steel arm 20, whose other end is welded to the inner surface of one end of a semi-circular metal screen 21 with an internal diameter Ø5 = 180 mm, whereby the metal screen 21 with its ends is also connected to two ball bearings 22 and 22' mounted on the external ends with larger diameters of the two-stage cylindrical elements 13 and 13'. The metal screen 21 is set in rotary motion by the stepper motor 18 and performs only half of the two-way rotations. The rotary shaft 19 of the stepper motor 18 powered by direct current with a voltage of 12 V - 48V from batteries 23 is also connected to the steel element 16, by means of a carbon brush 24 ensuring electrical connection between the metal screen 21 and the grounded steel element 17 of the housing 1.

In turn, in the through hole 5 of the cover 4 and inside the axial hole 5' of the two-stage cylindrical element 13 and partially inside the tubular shaft 6, a tubular guide 25 is mounted for wires coming out of the measuring system 26 - an electronic board enclosed in a metal housing of the Faraday cage type, containing a microprocessor 27 with an A/D converter, an operational amplifier 28, a resistor 29 with a resistance R = 5 MΩ and a reed switch 30, placed behind it in the tubular shaft 6. The reed switch 30 connected to the resistor 29 by a wire 31 placed in the hole 32 of the tubular shaft 6 is connected by soldering to the external measuring electrode 15, while the resistor 29 connected to the inputs of the operational amplifier 28 by a wire 33 through the hole 34 of the tubular shaft 6 is connected by soldering to the internal measuring electrode 14, which by a wire 35 is also connected by soldering to the grounded cover 4 of the housing 1. In turn, the stepper motor 18 is connected by a screened electric wire 36 through the hole 37 of the steel element 16 and the hole 37' of the cover 4 to the control unit 38, which controls the stepper motor 18 and processes data transmitted in numerical form by the measuring system 26. The control unit 38 placed in a technical room of the monitored building 39 and powered from the electrical grid with alternating current with a voltage of 230V is equipped with batteries 23 with a voltage of 12V - 48V, an LCD type liquid crystal screen - display 40, LED diodes 41 and controlling light outputs 42 with relays of measurement data, whereby the control unit 38 is connected by a screened electric wire 43 to the measuring system 26 and wirelessly connected to a computer 44 visualizing measurement data and recording this data in its memory and with light-sound signalling 45 and the signalling and executive devices 46, for example with a power supply disconnector from the power grid. The electric field intensity meter for thunderstorm cloud thus made is placed on a steel support structure 47 welded to its housing 1.

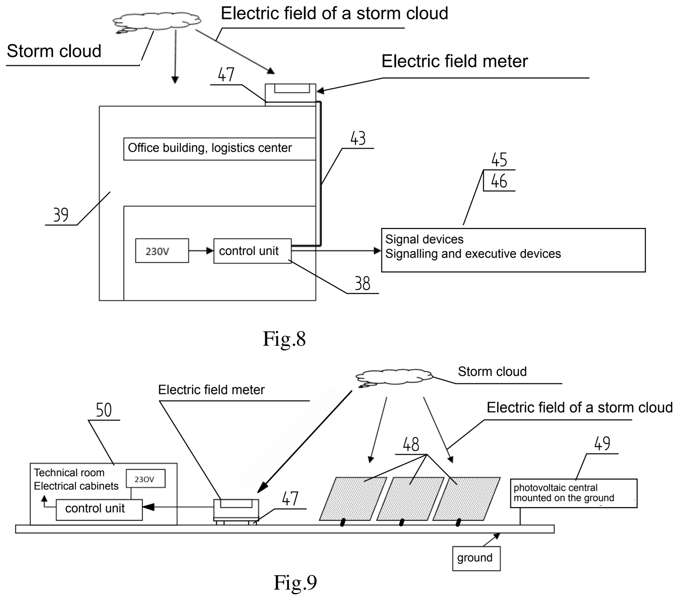

In the case of using the meter to monitor a building, for example an office building or a logistics centre, this meter is mounted on the roof of this building and is connected by screened electric wires 36 and 43 to the control unit 38 connected to the electrical grid, placed in a technical room of this building, which transmits signals (information) to the signalling and executive devices 46 as shown in fig. 8 and the computer 44.

In turn, in the case of using the electric field intensity meter for thunderstorm cloud to monitor photovoltaic panels 48 mounted together with their photovoltaic central 49 on the ground as shown in fig. 9, this meter is placed next to the photovoltaic panels 48 on a support structure not shown in the drawing at a height of 1m to 2m above the ground surface (in order to protect it from water and snow), while the control unit 38 is placed in a technical room 50 equipped with electrical cabinets and a technical supervision system, from where the signal in the form of technical alarms is transmitted to the supervision centre.

The continuously operating stepper motor 18 causing a half-turn of the screen 21 with a frequency of every 30 s, at the moment of detecting a thunderstorm cloud increases the frequency of half-turns of the screen 21 to 2-5 half-turns per second.

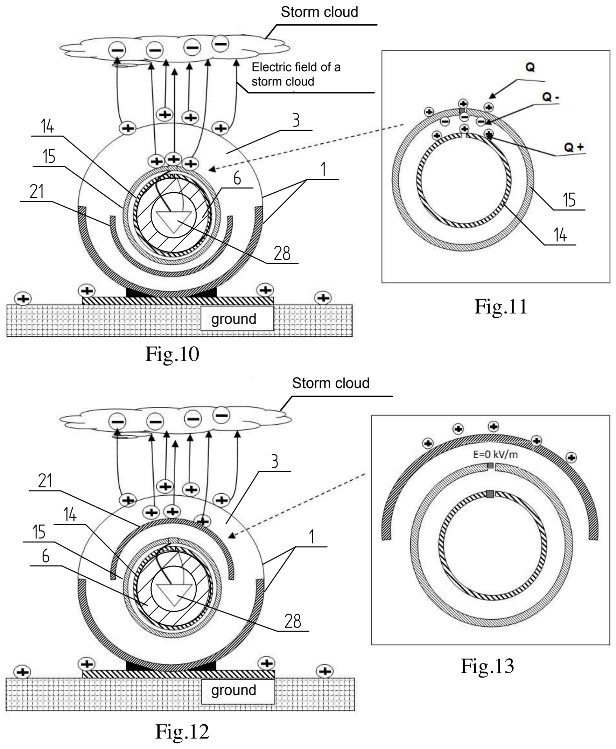

During a storm, the electric field of the thunderstorm cloud induces on the metal housing 1 of the meter and on the external surface of the external measuring electrode 15 having a free potential an electric charge Q, for example Q+ for a negatively charged thunderstorm cloud (fig. 10) and through capacitive coupling of this measuring electrode 15 with the grounded internal measuring electrode 14, charge Q (fig. 11) generates on the inner surface of the external measuring electrode 15 charge Q- and charge Q+ on the external surface of the internal measuring electrode 14.

Closing the contacts of the reed switch 30 causes the connection of both measuring electrodes 14 and 15 by the resistor 29 and the flow of electric current resulting from the compensation of charges Q + from the external surface of the internal measuring electrode 14 and Q- from the inner surface of the external measuring electrode 15, while the charge Q + on the external surface of the external electrode 15 still remains blocked by the electric field of the thunderstorm cloud. The voltage on the resistor 29 is proportional to the intensity of the electric field of the thunderstorm cloud and is measured after a few milliseconds from the moment of closing the contacts of the reed switch 30 by the operational amplifier 28 and is transmitted to the A/D converter of the microprocessor 27. The charge Q+ of the external electrode 15 blocked by the electric field of the thunderstorm cloud is zero in conditions of zero electric field of this cloud in the Faraday cage formed for this period of zeroing (lasting a few seconds), which is created by a half-turn of the metal screen 21 from the lower position to the upper position, as shown in fig. 12 and 13, and then after the zeroing period, the metal screen 21 returns to the lower position, and the meter goes back to the initial phase of measurement.

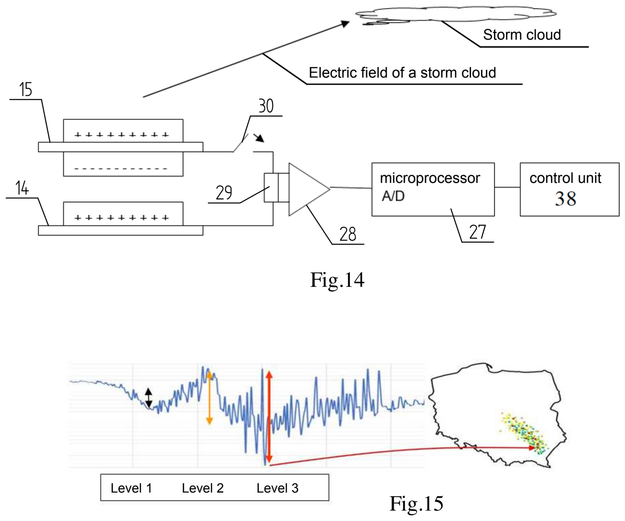

The principle of measuring the electric field intensity of the thunderstorm cloud is schematically presented in fig. 14. As shown in this figure, the essence of the measurement is that during the measurement, the charge generated by the field of the thunderstorm cloud is preserved on the external surface of the external measuring electrode 15 (marked in the figure as +), while due to the zero electric field in the metal from which the metal external measuring electrode 15 is made, the negative charge generated on the inner surface of this electrode was free and bound to itself the positive charge of the internal measuring electrode 14. Connecting these two electrodes in the state described above causes the flow of current through the resistor 29, and the value of voltage on this resistor is measured by the operational amplifier 28, and then is processed into a numerical signal and transmitted to the control unit 38, which signals by means of LED diodes 41 three states of danger: the first for electric field intensity 3kV/m, the second for the value 5kV/m and the third for the value above 7kV/m, and on the LCD display 40 displays the value of the electric field and transmits information about the danger through the controlling outputs to the signalling and executive devices 46. After the measurement stage, the metal screen 21 moves to the upper position and remains in this position, cutting off the electric field from the external measuring electrode 15, which is discharged within about 2 seconds, as a result of connecting it through the resistor 29 and the reed switch 30 to the grounded internal measuring electrode 14.

Then, after the discharge stage, the screen 21 is moved to the lower position and the electric field of the thunderstorm cloud is measured again, whereby the time between repeated measurements is 3 - 5 seconds. With a thunderstorm cloud speed of 100 km/hour, its displacement between two measurements is 30 m/s x 5 = 150m, while measurement from a distance of 10 km gives a resolution of about 2%, and the reaction time of the signalling and executive devices is about 6 minutes.

As a result of conducted tests, it was established that a thunderstorm cloud located at a distance of about 20 km from the monitored object produces an electric field, the intensity of which registered by the meter is E = 1 - 2 kV/m;
- a thunderstorm cloud at a distance of about 10 km is equivalent to an electric field with an intensity of about 3 - 4 kV/m (a signal of the first level of danger is transmitted)
- a thunderstorm cloud at a distance of 5 km is equivalent to an electric field with an intensity E = 5 - 7 kV/m (a signal of the second level of danger is transmitted)
- a thunderstorm cloud at a distance of 3 km is equivalent to an electric field with an intensity E = 8 - 10 kV/m (a signal of the third level of danger is transmitted)
- if the meter indicates an intensity value above 10kV, it means that an atmospheric discharge will occur within a radius of 1km.

The graph in fig. 15 shows the measured electric field intensity of a thunderstorm cloud from a distance of about 15 km from the monitored object.

The electric field intensity on the left side of the graph is about zero, then there is an increase in intensity from a negatively charged cloud, and then a change in cloud charge to positive (because there is no thunderstorm cloud charged with the same name), whereby a change in field amplitude of about 3 kV/m generates a warning of the first level of danger, a change in field amplitude of about 5 kV/m generates a warning of the second level of danger, while a change in field amplitude above 7 kV/m generates a warning of the third level of danger, that is, of danger of a ground discharge.

In further examples of execution, the electric field intensity meters for thunderstorm clouds had:
- housings 1 of stainless steel in the shapes of cylindrical pipes with lengths L = 480 mm or L = 520 mm and diameters Ø = 190 mm or 210 mm, and their semi-pipe recesses had lengths L1 = 190 mm or L1 = 210 mm
- tubular shafts 6, discs 11 and 11' and two-stage cylindrical elements 13 and 13' made of polysulfone
- dielectric tubular shafts 6 with external diameters Ø1 = 75 mm or 84 mm and internal diameters Ø2 = 10 mm or 35 mm made-of polysulfone
- internal measuring electrodes 14 with external diameters Ø4 = 75mm or 84 mm made of stainless steel or copper
- semi-circular steel screens 21 with internal diameters Ø5 = 178 mm or 182 mm
- measuring electrodes 14 and 15 made of stainless steel and electrically connected to each other by means of a resistor 29 with a resistance R = 4 MΩ or R = 6 MΩ, and the height of the gap between these electrodes was h = 1 mm or 5 mm,
whereby these meters also fulfilled their purpose like the meter described in the first example.

## Claims

1. An electric field meter for thunderstorm cloud containing measuring electrodes, including an electrode collecting electric charges induced by the electric field of the thunderstorm cloud and a measuring system connected to a control unit connected to a computer and the signalling and executive devices **characterised in that** it has a grounded metal housing (1) in the shape of a cylindrical pipe with a length L = 480 - 520 mm and a diameter Ø = 190 - 210 mm, which in the middle upper part has a semi-pipe recess (2) with a length L1 = 190 - 210 mm, serving as a measurement window (3), whereby one external opening of the housing (1) is blinded with a flat steel cover (4) fitted in it and connected to it non-detachably with an axial through hole (5), and the second external opening of this housing is blinded with a flat steel cover (4') fitted in it and connected to it non-detachably, while inside the housing (1) in its axis of symmetry, there is placed a tubular shaft (6) made of dielectric material with an external diameter Ø1 = 75 - 84 mm, having at both its ends external ring recesses (8 and 8') connected detachably with metal angle rings (10 and 10'), on which is mounted a fixed grounded tubular metal internal measuring electrode (14) adjacent to the tubular shaft (6), while to both faces of the tubular shaft (6) and the faces of both angle rings (10 and 10') are adjacent dielectric discs (11 and 11') with coaxially situated holes with a diameter equal to the diameter of the tubular shaft (6), in which are mounted dielectric two-stage cylindrical elements (13 and 13') screwed into both ends of the tubular shaft (6), in turn on the inner surfaces of the dielectric discs (11 and 11') shallow ring sockets (12 and 12') are made, in which the ends of the metal external measuring electrode (15) are mounted, glued with epoxy glue, and between this electrode and the metal internal measuring electrode (14) a gap with a height h = 1 - 5mm is formed, moreover inside the tubular shaft (6) a measuring system (26) is placed, whose reed switch (30) connected to a resistor (29) by an electric wire (31) placed in the hole (32) of the tubular shaft (6) is connected non-detachably to the external measuring electrode (15), while the resistor (29) connected to the inputs of the operational amplifier (28) by an electric wire (33) through the hole (34) of the tubular shaft (6) is connected non-detachably to the internal measuring electrode (14), which by an electric wire (35) is connected non-detachably to the grounded cover (4) of the housing (1), whereby the measuring system (26) is connected by an electric wire (43) through wires placed in the tubular guide (25) mounted in the through hole (5) of the cover (4) and inside the axial hole (5') of the two-stage cylindrical element (13) and partially inside the tubular shaft (6) with the control unit (38) controlling the operation of the stepper motor (18) connected to it by an electric wire (36), mounted in the steel support element (17) welded to the inner surface of the housing (1) behind the cover (4'), whereby the rotary shaft (19) of the stepper motor (18), powered by direct current with a voltage of 12 - 48 V from batteries (23) through a steel arm (20) is connected to a semi-circular metal screen (21) with an internal diameter Ø5 = 178 - 182 mm, which is also connected to two ball bearings (22 and 22') mounted on the external ends with larger diameters of both dielectric two-stage cylindrical elements (13 and 13'), and moreover, the rotary shaft (19) of the stepper motor (18) by means of a carbon brush (24) is connected to a steel element (16) adjacent to the face of the dielectric two-stage cylindrical element (13') and welded to the inner surface of the housing (1).

2. The meter according to claim 1 **characterised in that** the measuring system (26) placed in a metal housing of the Faraday cage type, consists of a microprocessor (27) with an A/D converter, an operational amplifier (28), a resistor (29) with a resistance R = 4 - 6 MΩ and a reed switch (30).

3. The meter according to claim 1 **characterised in that** the control unit (38) placed in a technical room powered from the electrical grid with alternating current with a voltage of 230V is equipped with batteries (23) with a voltage of 12V - 48V, an LCD type liquid crystal screen - display (40), LED diodes (41) and with controlling light outputs (42) with relays of measurement data and is wirelessly connected to a computer (44), with light-sound signalling (45) and the signalling and executive devices (46).

4. The meter according to claim 1 **characterised in that** the steel screen (21) is set in rotary motion by the stepper motor (18) and performs only half of the two-way rotations.

5. The meter according to claim 1 **characterised in that** both measuring electrodes (14 and 15) are electrically connected to each other by means of a resistor (29).

6. The meter according to claim 1 **characterised in that** the tubular shaft (6), discs (11 and 11') and two-stage cylindrical elements (13 and 13') are made of Teflon.

7. The meter according to claim 1 **characterised in that** the tubular shaft (6), discs (11 and 11') and two-stage cylindrical elements (13 and 13') are made of polysulfone.

8. The meter according to claim 1 **characterised in that** both measuring electrodes (14 and 15) are made of brass or stainless steel or copper.

9. The meter according to claim 1 **characterised in that** the housing (1), covers (4 and 4') and structural elements (16 and 17) are made of stainless steel.

10. The meter according to claim 1 **characterised in that** the electric wires (36 and 43) are screened wires.
